(19) Europäisches Patentamt
European Patent Office
Office européen des brevets

(11) **EP 2 436 114 B1**

(12) **EUROPEAN PATENT SPECIFICATION**

(45) Date of publication and mention
of the grant of the patent:
**10.07.2019 Bulletin 2019/28**

(21) Application number: **10845990.0**

(22) Date of filing: **20.02.2010**

(51) Int Cl.:
***H03H 17/00*** (2006.01)

(86) International application number:
**PCT/CN2010/070695**

(87) International publication number:
**WO 2011/100868 (25.08.2011 Gazette 2011/34)**

(54) **FILTER DEVICE AND METHOD FOR PROVIDING A FILTER DEVICE**

FILTERVORRICHTUNG UND VERFAHREN ZUR BEREITSTELLUNG EINER FILTERVORRICHTUNG

DISPOSITIF DE FILTRE ET PROCÉDÉ DESTINÉ À FOURNIR UN DISPOSITIF DE FILTRE

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(43) Date of publication of application:
**04.04.2012 Bulletin 2012/14**

(73) Proprietor: **Huawei Technologies Co., Ltd.**
**Shenzhen, Guangdong 518129 (CN)**

(72) Inventors:
• **XIE, Changsong**
**Shenzhen (CN)**
• **FABIAN, Nikolaus Hauske**
**Shenzhen (CN)**

(74) Representative: **Kreuz, Georg Maria**
**Huawei Technologies Duesseldorf GmbH**
**Riesstraße 25**
**80992 München (DE)**

(56) References cited:
**EP-A1- 1 557 947        CN-A- 1 516 923**
**CN-A- 1 706 101         CN-A- 1 706 101**
**CN-A- 101 228 690       CN-A- 101 320 996**
**DE-A1-102006 053 508    JP-A- 58 107 712**
**US-A- 3 599 108         US-A1- 2009 134 938**
**US-B1- 7 120 656**

**Description**

BACKGROUND OF THE INVENTION

The present invention relates to filter devices, like Finite Impulse Response (FIR) filters, in particular in optical communication systems.

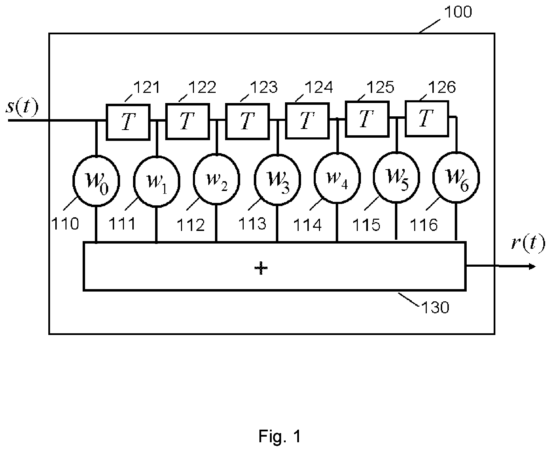

An FIR filter conventionally has a constant time delay or delay between its adjacent taps. In this regard, Fig. 1 shows an FIR filter 100 which is configured to filter an input signal s(t) for providing a filtered output signal r(t). The FIR filter 100 has a plurality of taps 110-116 with a respective filter coefficient $w_0$-$w_6$. Further, the FIR filter 100 has a plurality of delay elements 121-126, wherein the delay elements 121-126 have a respective constant delay T. The outputs of the taps 110-116 are added by an adder entity 130 for providing the filtered output signal r(t).

The sum of all time delays T defines the impulse response time of the FIR filter 100. For equalization, the filter impulse response time should be larger or equal to the channel memory time. Otherwise, channel impairments may not be fully compensated.

Such a conventional FIR filter, also called transversal filter, employs said equally spaced time delays or delays T between the adjacent taps such that the filtered output results in $r(t) = w_M s(t - MT) + w_{M-1} s(t - (M-1)T) +... + w_1 s(t - T) + w_0 s(t)$ with the filtered signal $r(t)$, the input signal $s(t)$, filter coefficients or tap weights $w_i$, $i \in \{0,1,...,M\}$ and a tap delay $T$. Typically, the delay $T$, also called tap delay $T$, refers to the symbol duration $T_S$. In optical communication systems, a tap delay of $T = T_S/2$ is employed, which refers to two-fold over-sampling relative to the Baudrate. The benefit of over-sampling with a finer resolution of the tap spacing is demonstrated for optical transmission systems by T. Duthel, et al. "Impairment tolerance of 111Gbit/s POLMUX-RZ-DQPSK using a reduced complexity coherent receiver with a T-spaced equalizer", European Conference on Optical Communication, Berlin, Germany, paper Mo.1.3.2, Sept. 16-20, 2007.

For reducing implementation complexity, the total number of taps should be as low as possible, e.g. a total number of nine taps, which may refer to an impulse response duration of the FIR filter of 4T. There might be channel conditions where the channel memory exceeds the impulse response time of the FIR filter, e.g. by large differential group delay (DGD). For covering such cases, the filter impulse response time has to be increased.

In this regard, a basis for the above may be found in Simon Haykin, "Adaptive Filter Theory", 4th edition, Prentice Hall, 2002, Chapter "Background and preview", Section 4: Linear Filter Structures, and in Nevio Benvenuto and Giovanni Cherubini, "Algorithms for Communications Systems and their Applications", Wiley, 2002, Chapters 1.3-1.4.

Moreover, given a constant number of taps, either a spacing of $2T = T_s$ is applied which has an extended filter impulse response, but which suffers a principal filtering penalty in optical systems as mentioned above. Here, document US 5,838,740 A describes $T=T_S/2$ spaced FIR taps that only cover half of the filter impulse duration.

US 7,120,656 relates to a Finite Impulse Response (FIR) filter including a coefficient generator to generate first and second coefficients, a first control conductor, and a second control conductor. A controller is coupled to a first end of the first control conductor and a first end of the second control conductor. A shared wiring is provided having its first end coupled to the coefficient generator.

US 3,599,108 relates to a discrete-time filter, wherein sensitivity to coefficient variation is substantially reduced by using a unit delay interval, for the delay networks of the filter, which is not equal to the sampling interval. Furthermore, in realizing higher order filter systems, a plurality of such filters may be cascaded, each having a delay interval different from that of the other filters.

US 2009/0134938 relates to a charge domain filter circuit including a first signal output portion, at least one second signal output portion, a third signal output portion, and an adder portion. The first signal output portion outputs a first signal that is sampled at a specified time interval. Each second signal output portion outputs a second signal that is sampled after a specified delay after the first signal is sampled. The third signal output portion outputs a third signal that is sampled after a specified delay after the last second signal is sampled.

DE 10 2006 053 508 relates to a method for digital signal processing, wherein a Finite Impulse Response (FIR) filter in cascaded form or parallel form is used.

EP 1 557 947 A1 relates to a symmetric unit filter being designed by combining in series two unit filters having asymmetric numerical sequences as filter coefficients.

SUMMARY OF THE INVENTION

A goal to be achieved by the present invention is to provide a trade off between a long filter impulse duration and a high resolution. This may be achieved by a hybrid filter structure of the present invention with different delays according to the independent claim. The dependent claims relate to preferred embodiments of the present invention.

Thus, according to some implementations, various delays or tap delays may be incorporated in one filter design. The delay structure may be made adaptive, by including or excluding delay elements between two adjacent taps, in order to adjust the structure to the channel memory or it may be static designed to meet a certain requirement.

The channel memory may cause signal impulses to spread over several symbol slots such that they may interfere with the adjacent pulses. Particularly, the edges of a pulse may only contain little pulse energy compared to the pulse center. Thus, the information about the pulse close to its edge is low compared to the pulse center. The FIR filter in an equalizer may try to supply the inverse channel impulse response such that the pulse spreading of the channel is reversed and an undistorted pulse may be obtained after equalization. A short delay between the FIR filter taps, which refers to a high sampling rate, may provide a better resolution with an enhanced presentation of the inverse channel impulse response than a long delay, Therefore, a larger total number of taps may be required to cover a certain filter impulse duration when the tap delay is reduced, in particular in systems with over-sampling. In contrast, a long delay between the FIR filter taps, which refers to a low sampling rate, leads to a long filter impulse duration compared on the basis of the number of taps, which may compensate for a longer channel impulse response.

Analogously, the benefit of a short tap delay and a long filter impulse duration may be explained by the frequency domain representation of the FIR filter, also referred to the filter transfer function. The sampling rate defines the digital bandwidth, with a large sampling rate leading to a large digital bandwidth. The number of FIR taps refers to the number of frequency domain representatives of the transfer function within the digital bandwidth.

A short tap delay may refer to a large sampling rate with a wide digital bandwidth, which may avoid overlapping of the upper and lower sideband of the transfer function, also referred to as aliasing. A long tap delay refers to a low sampling rate with a small digital bandwidth. If the sampling rate satisfies the first Nyquist criterion, there is no aliasing. Given the same number of FIR taps, the transfer function for a shorter tap delay has a coarser frequency resolution with a less accurate representation of the transfer function. On the other hand, the transfer function for a longer tap delay has a finer frequency resolution with a more accurate representation of the transfer function. In optical transmission systems, a sampling rate of one sample per symbol ($T=T_s$) typically does not satisfy the Nyquist criterion. Preferable, a sampling rate of two samples per symbol is applied ($T=T_s/2$).

Further, according to some implementations, a low back to back penalty may be provided with a high resolution.

Moreover, according to some implementations, the robustness to all residual distortions prior to a time-domain filter stage at a given implementation complexity, i.e. at a total number of taps, may be increased. Further, the required number of taps may be reduced to reach a certain tolerance against linear channel distortions.

According to the invention, a filter device for filtering an input signal as defined in claim 1 is provided.

The filter device has a plurality of taps having a respective filter coefficient, and a plurality of delay elements, wherein at least two delay elements have different delays.

The filter device may be a digital filter, in particular a Finite Impulse Response (FIR) filter. Alternatively, the filter device may be an Infinite Impulse Response (IIR) filter. Further, the input signal may be an electrical input signal, in particular after an optical transmission. Furthermore, the input signal may be an optical input signal.

An example of the filter of the present invention may be a filter with a structure, where the taps in the center of the filter structure differ by a delay or tap delay of $T=T_s/2$ and at either side of the filter, the edges, the taps may differ by an extended tap delay of $2T=T_s$. In an example of a filter having nine taps, the five center taps may have a delay of T and the two taps of each edge may differ by a delay of 2T. The closer tap spacing at the center may provide a good equalization with a detailed representation of the filter function. The larger delay at the edges of the hybrid filter may increase the total impulse response time of the filter, and thus may allow equalization of channel conditions with large memory.

According to some implementations, an arbitrary delay or time shift by factors $\alpha_i$ with $\alpha_{i-1} < \alpha_i < \alpha_{i+1}$  $\alpha \in R$, with $\alpha_i$ being a real number, may lead to

$$r(t) = w_M s(t - \alpha_M T) + w_{M-1} s(t - \alpha_{M-1} T) + \ldots + w_1 s(t - \alpha_1 T) + w_0 s(t - \alpha_0 T).$$

In particular, a digital system may be confined to the sampling rate at the analog-to-digital conversion (ADC) with a sampling rate of $N/T_S$ which leads to a sample time $T_S/N$. The tap delay may be whole-number multiple $\beta_i, \beta_i \in Z$, with $\beta_i$ being a positive or a negative natural number, of the delay $T = T_S / N$. The filtered output signal $r(t)$ may be described as:

$$r(t) = w_M s(t - \beta_M T) + w_{M-1} s(t - \beta_{M-1} T) + \ldots + w_1 s(t - \beta_1 T) + w_0 s(t - \beta_0 T)$$

Particularly, $\beta_i$ maybe chosen to be $\beta = [9,7,6,5,4,3,2,0]$, which leads to a wider spacing at both edges of the filter and a narrow spacing at the center of the filter.

According to the invention, the respective delay element are arranged between two taps.

According to an implementation form, each tap may have one filter coefficient and one delay element.

According to the invention, the filter device comprises adjusting means for adjusting the delays of the delay elements of the filter device.

Advantageously, by means of the adjusting means, the filter device is adjustable and therefore adaptive.

According to an implementation form, said adjusting means may adjust the delay of the respective delay element in dependence on a position of the respective delay element in the filter device.

According to the invention, the plurality of delay elements are connected in a series connection. Said series connection has a number of center delay elements arranged in a center of the series connection and a respective number of edge delay elements arranged on edges of the series connection. The respective delay of the center delay elements is smaller than the respective delay of the edge delay elements. In particular, said adjusting means may adjust a delay between center taps smaller than a delay between edged taps of the filter device.

According to the invention, all delay elements are connected in a series connection. Said series connection has a number of center delay elements arranged in a center of the series connection and a respective number of edge delay elements arranged on edges of the series connection. The respective delay of the center delay elements is the half of the respective delay of the edge delay elements.

According to an implementation form, said adjusting means is configured to adjust the delays of the delay elements of the filter device, in particular to adjust the respective delay to be a multiple of a quotient between symbol duration of the input signal and an oversampling rate used for sampling the input signal.

According to an implementation form, the delay elements of the filter device may have several different delays. Thus, also more complex filter functions may be provided by the filter device of the present invention.

According to an implementation form, the filter device may have setting means for setting a delay between two adjacent taps by including or excluding one or more delay elements between the two adjacent taps.

The respective means, in particular the adjusting means and the setting means may be implemented in hardware or in software. If said means are implemented in hardware, it may be embodied as a device, e.g. as a computer or as a processor, or as a part of a system, e.g. a computer system. If said means are implemented in software, it may be embodied as a computer program product, as a function, as a routine, as a program code or as an executable object.

According to an implementation form, the respective delay of two adjacent taps is static.

According to another implementation form, a filter arrangement is provided, wherein said filter arrangement has a plurality of above described filter devices.

According to the invention, a method for providing a filter device for filtering an input signal as defined in claim 8 is provided, the method comprising a step of providing a plurality of taps with a respective filter coefficient, and a step of providing a plurality of delay elements, wherein at least two delay elements have different delays, and providing adjusting means for adjusting the delays of the delay elements of the filter device, wherein the respective delay element is arranged between two taps.

The method according to the invention comprises a step of adjusting the delays starting to extend the delays of outer delay elements of the series connection first such that a filter memory of the filter device is increased.

## BRIEF DESCRIPTION OF THE DRAWINGS

Further embodiments of the invention will be described with respect to the following figures, in which:

Fig. 1 shows a filter device with constant delays,

Fig. 2 shows an embodiment of a filter device with different delays,

Fig. 3 shows a diagram illustrating a dependence of a required optical signal-to-noise-ratio to reach a bit-error-rate of $10^{-3}$ versus an optical channel impairment differential group delay for three different filter lengths,

Fig. 4 shows a diagram illustrating a filter impulse response for a differential group delay value of 0,

Fig. 5 shows a diagram illustrating a filter impulse response for a differential group delay value of 36 ps,

Fig. 6 shows a diagram illustrating a filter impulse response for a differential group delay value of 72 ps,

Fig. 7 shows a diagram illustrating an improvement for differential group delay tolerance,

Fig. 8 shows a diagram illustrating an improvement for chromatic dispersion tolerance,

Fig. 9 shows an embodiment of a method for providing a filter device, and

Fig. 10 shows an embodiment of a method for adjusting a filter device.

DETAILED DESCRIPTION OF EMBODIMENTS OF THE INVENTION

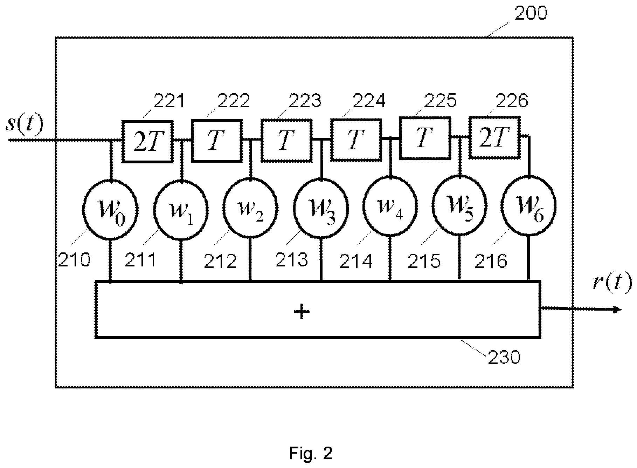

Fig. 2 shows an embodiment of a filter device 200 with different delays T, 2T.

The filter device 200 may be an FIR filter. The FIR filter 200 of Fig. 2 receives an input signal s(t) and outputs a filtered output signal r(t). The FIR filter 200 has seven taps 210-216. The respective tap 210-216 has a respective filter coefficient $w_0$-$w_6$. For example, the tap 211 has the filter coefficient $w_1$. Further, the FIR filter 200 has six delay elements 221-226. The delay elements 221-226 are arranged between two taps 210-216, respectively. The number of taps 210-216 and the number of delay elements 221-226 is only exemplarily in Fig. 2.

The center delay elements 222 to 225 of Fig. 2 have a tap delay of T. In contrast, the edge delay elements 221 and 226 have a delay of 2T. Also, this structure is only exemplarily. By way of example, also the delay elements 222 and 225 may have a delay of 2T.

The output of the taps 210-216 is added by an adder entity 230 to provide the output signal r(t).

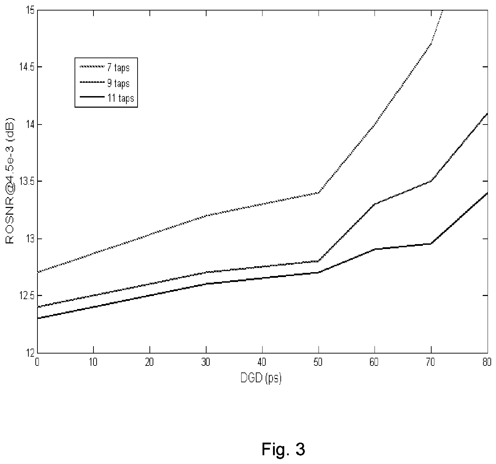

Referring to Figs. 3 to 6, the optical channel impairment differential group delay (DGD) may introduce linear distortions, which may increase the channel memory. The length of the filter impulse response may be adapted to be longer or equal the length of the channel impulse response to allow penalty-free compensation of the channel impairments. Otherwise, the Bit Error Rate (BER) may be degraded or a higher Signal-to-Noise-Ratio (SNR) may be required to keep the BER constant.

In this regard, Fig. 3 shows a diagram illustrating a dependence of a Required Optical Signal-to-Noise-Ratio (OSNR) on optical channel impairment Differential Group Delay (DGD). In particular, Fig. 3 shows the required Optical Signal-to-Noise-Ratio (OSNR) versus DGD with different tap lengths. A length of nine taps may be sufficient up to 50ps of DGD. Further, eleven taps may extend DGD range up to 70ps.

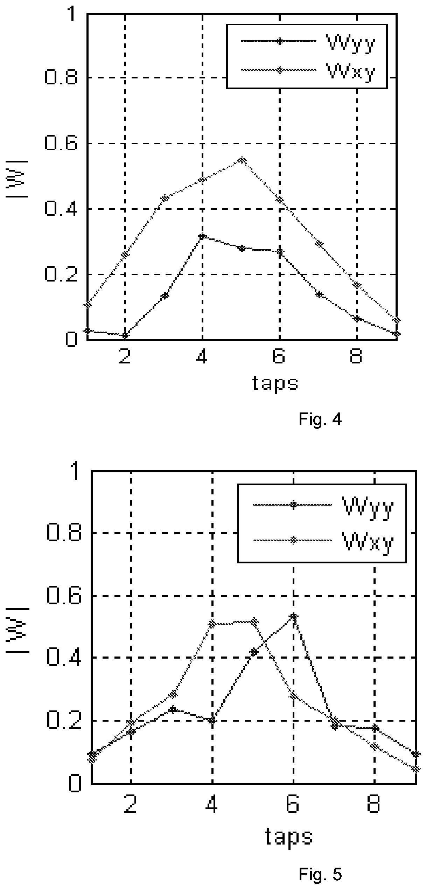

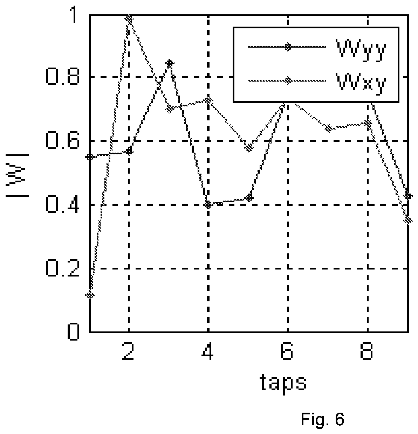

Furthermore, Fig. 4 shows a diagram illustrating a filter impulse response for a Differential Group Delay (DGD) value of 0. In an analogous way, figures 5 and 6 show the same for 36ps and 72ps, respectively. With reference to Fig. 6, for 72ps of DGD, the filter memory may be already too short. Taps close to the edges may not decline to zero. In such a case, eleven taps would be required instead of nine taps to reach the required length of the filter impulse response.

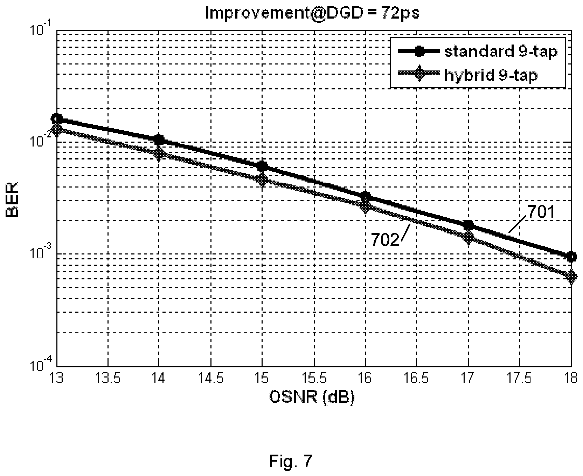

In Fig. 7, a diagram is depicted for illustrating an improvement for Differential Group Delay (DGD) tolerance. Particularly, curve 701 shows the case for a standard 9-tap filter FIR and, in contrast, curve 702 shows the case for a hybrid 9-tap FIR filter. Because curve 701 is clearly over curve 702, the improvement of the hybrid delay structure compared to a standard FIR structure with constant tap delay is clearly shown. The hybrid delay structure may apply a 2T delay at the edges of the filter and T delay for the center taps, as shown in Fig. 2, for example. This may extend the filter impulse response length to 10T compared to 8T of a standard FIR structure, as exemplarily shown in Fig. 1.

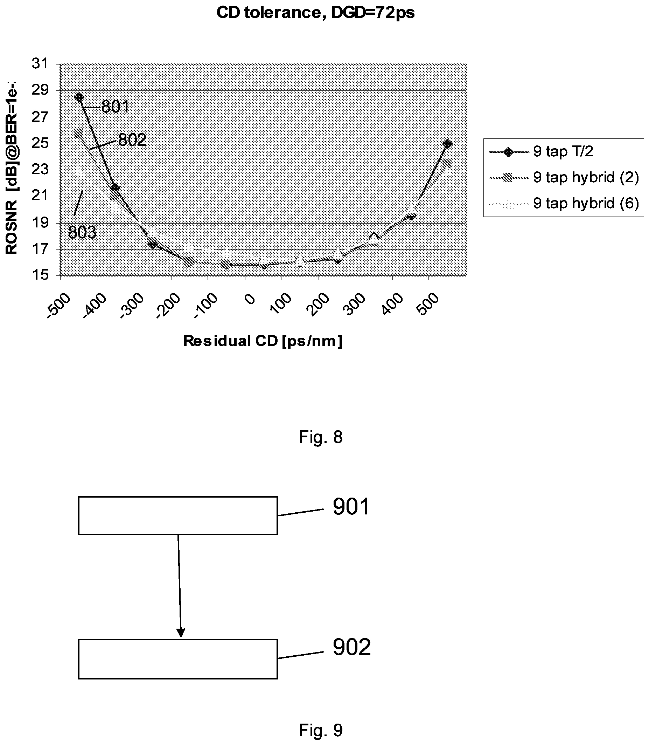

Figure 8 shows a diagram illustrating an improvement for chromatic dispersion (CD) tolerance. The x-axis of Fig. 8 shows the residual CD in ps/nm. Further, the y-axis shows the required OSNR (ROSNR). Figure 8 shows three curves 801-803. The curve 801 is based on a filter structure with nine taps having a respective constant delay of $T=T_s/2$. The hybrid delay structures of curves 802 and 803 apply nine taps with a $2T=T_s$ delay at the edges of the filter. In this regard, "hybrid (2)" of curve 802 applies an extended delay to one tap at each filter side, in sum two extended delays of 2T. Further, "hybrid (6)" of curve 803 applies an extended delay to three taps at each filter side, in sum six extended delays of 2T. Especially, for large values of CD, where the standard FIR structure according to curve 801 is already limited by its slow impulse length, the hybrid structure according to curves 802, 803 with its extended impulse length proves a clear benefit according to Fig. 8.

In Fig. 9, an embodiment of the method for providing a filter device is depicted.

As shown in Fig. 9, the method comprises a step of providing 901 a plurality of taps having a respective filter coefficient. Further, the method of Fig. 9 comprises a step of providing 902 a plurality of delay elements, wherein at least two delay elements have different delays.

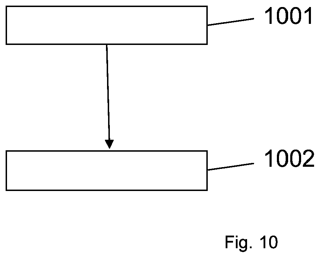

Furthermore, in Fig. 10, an embodiment of the method for adjusting a filter device according to the invention is depicted, said filter device having a plurality of taps having a respective filter coefficient and a series connection of a plurality of delay elements. An example of such a filter is shown in Fig. 2.

The method of Fig. 10 comprises a step of providing 1001 the delay elements with adjustable delays.

Furthermore, the method of Fig. 10 has a step of adjusting 1002 the delays starting to extend the delays of outer delay elements of the series connection first such that the filter memory of the filter device is increased.

According to some implementations, the filter device is embodied as a Finite Impulse Response (FIR) filter. Further, the present invention may be also embodied as an Infinite Impulse Response (IIR) filter.

**Claims**

1. Filter device (200) for filtering an input signal (s(t)), comprising:

   a plurality of taps (210-216) having a respective filter coefficient ($w_0$-$w_6$), and a plurality of delay elements (221-226), wherein at least two delay elements (221-226) have different delays,
   **characterized by** further comprising adjusting means configured to adjust the delays of the delay elements (221-226) of the filter device (200), wherein the delay elements (221-226) are connected in series to form a series connection, said series connection having a number of center delay elements (222-225) arranged in a center of the series connection and a respective number of edge delay elements (221, 226) arranged on edges of the series connection, wherein the respective delay of the center delay elements (222-225) is smaller than the respective delay of the edge delay elements (221, 226), and wherein the respective delay element (221-226) is arranged between two taps (210-216); and
   wherein the adjusting means is configured to extend the delays of edge delay elements (221, 226) of the series connection first such that a filter memory of the filter device is increased.

2. Filter device (200) of claim 1,
   comprising adjusting means configured to adjust the delay of the respective delay element (221-226) in dependence on a position of the respective delay element (221-226) in the filter device (200).

3. Filter device (200) of one of the preceding claims,
   wherein the respective delay of the center delay elements (222-225) is the half of the respective delay of at least one of the edge delay elements (221, 226).

4. Filter device (200) of one of the preceding claims,
   comprising adjusting means for adjusting the delays of the delay elements (221-226) of the filter device (200), wherein the adjusting means are configured to adjust the respective delay to be a multiple of a quotient between a symbol duration of the input signal (s(t)) and an oversampling rate used for sampling the input signal (s(t)).

5. Filter device (200) of one of the preceding claims,
   wherein the delay elements (221-226) of the filter device (200) have at least three different delays.

6. Filter device (200) of one of the preceding claims,
   wherein the filter device (200) is a Finite Impulse Response, FIR, filter.

7. Filter arrangement, comprising:
   a plurality of filter devices (200) of one of the preceding claims configured to filter the input signal (s(t)).

8. Method for providing a filter device (200) for filtering an input signal (s(t)), the method comprising:

   providing a plurality of taps (210-216) having a respective filter coefficient ($w_0$-$w_6$), and
   providing a plurality of delay elements (221-226) arranged in a series connection, wherein at least two delay elements (221-226) have different delays, wherein a number of center delay elements (222-225) is arranged in a center of the series connection and a respective number of edge delay elements (221, 226) is arranged on edges of the series connection, wherein the respective delay of the center delay elements (222-225) is smaller than the respective delay of the edge delay elements (221, 226);
   the method **characterized in that** it further provides adjusting means configured to adjust the delays of the delay elements (221-226) of the filter device (200), wherein the respective delay element (221-226) is arranged between two taps (210-216), and
   wherein the adjusting means is configured to extend the delays of edge delay elements (221, 226) of the series connection first such that a filter memory of the filter device is increased.

**Patentansprüche**

1. Filtervorrichtung (200) zum Filtern eines Eingangssignals (s(t)), umfassend:

   mehrere Abgriffe (210-216) mit einem entsprechenden Filterkoeffizienten ($w_0$-$W_6$), und

mehrere Verzögerungselemente (221-226), wobei mindestens zwei Verzögerungselemente (221-226) unterschiedliche Verzögerungen aufweisen,

**gekennzeichnet durch** ferner umfassend

Einstellmittel, die zum Einstellen der Verzögerungen der Verzögerungselemente (221-226) der Filtervorrichtung (200) ausgelegt sind, wobei die Verzögerungselemente (221-226) in Reihe geschaltet sind, um eine Reihenschaltung zu bilden, wobei die Reihenschaltung eine Anzahl von mittleren Verzögerungselementen (222-225) aufweist, die in einer Mitte der Reihenschaltung angeordnet sind, und eine entsprechende Anzahl von Rand-Verzögerungselementen (221, 226), die an Rändern der Reihenschaltung angeordnet sind, wobei die jeweilige Verzögerung der mittleren Verzögerungselemente (222-225) kleiner ist als die jeweilige Verzögerung der Rand-Verzögerungselemente (221, 226), und wobei das jeweilige Verzögerungselement (221-226) zwischen zwei Abgriffen (210-216) angeordnet ist; und

wobei die Einstellmittel zum Verlängern der Verzögerungen von Rand-Verzögerungselementen (221, 226) der Reihenschaltung zunächst so ausgelegt sind, dass ein Filterspeicher der Filtervorrichtung erhöht wird.

2. Filtervorrichtung (200) nach Anspruch 1,
umfassend Einstellmittel, die zum Einstellen der Verzögerung des jeweiligen Verzögerungselements (221-226) in Abhängigkeit von einer Position des jeweiligen Verzögerungselements (221-226) in der Filtervorrichtung (200) ausgelegt sind.

3. Filtervorrichtung (200) nach einem der vorhergehenden Ansprüche,
wobei die jeweilige Verzögerung der mittleren Verzögerungselemente (222-225) die Hälfte der jeweiligen Verzögerung von mindestens einem der Rand-Verzögerungselemente (221, 226) ist.

4. Filtervorrichtung (200) nach einem der vorhergehenden Ansprüche,
umfassend Einstellmittel zum Einstellen der Verzögerungen der Verzögerungselemente (221-226) der Filtervorrichtung (200), wobei die Einstellmittel zum Einstellen der jeweiligen Verzögerung ausgelegt sind, ein Vielfaches eines Quotienten zwischen einer Symboldauer des Eingangssignals (s(t)) und einer zum Abtasten des Eingangssignals (s(t)) verwendeten Überabtastrate zu sein.

5. Filtervorrichtung (200) nach einem der vorhergehenden Ansprüche,
wobei die Verzögerungselemente (221-226) der Filtervorrichtung (200) mindestens drei verschiedene Verzögerungen aufweisen.

6. Filtervorrichtung (200) nach einem der vorhergehenden Ansprüche,
wobei die Filtervorrichtung (200) ein Filter mit endlicher Impulsantwort, FIR, ist.

7. Filteranordnung, umfassend:
mehrere Filtervorrichtungen (200) eines der vorhergehenden Ansprüche, die zum Filtern des Eingangssignals (s(t)) ausgelegt sind.

8. Verfahren zum Bereitstellen einer Filtervorrichtung (200) zum Filtern eines Eingangssignals (s(t)), wobei das Verfahren umfasst:

Bereitstellen mehrerer Abgriffe (210-216) mit einem entsprechenden Filterkoeffizienten ($w_0$-$w_6$), und
Bereitstellen mehrerer Verzögerungselemente (221-226), die in einer Reihenschaltung angeordnet sind, wobei mindestens zwei Verzögerungselemente (221-226) unterschiedliche Verzögerungen aufweisen, wobei eine Anzahl von mittleren Verzögerungselementen (222-225) in einer Mitte der Reihenschaltung angeordnet ist und eine entsprechende Anzahl von Rand-Verzögerungselementen (221, 226) an Rändern der Reihenschaltung angeordnet ist, wobei die jeweilige Verzögerung der mittleren Verzögerungselemente (222-225) kleiner als die jeweilige Verzögerung der Rand-Verzögerungselemente (221, 226) ist;
wobei das Verfahren **dadurch gekennzeichnet ist, dass** es ferner bereitstellt Einstellmittel, die zum Einstellen der Verzögerungen der Verzögerungselemente (221-226) der Filtervorrichtung (200) ausgelegt sind, wobei das jeweilige Verzögerungselement (221-226) zwischen zwei Abgriffen (210-216) angeordnet ist, und
wobei die Einstellmittel zum Verlängern der Verzögerungen von Rand-Verzögerungselementen (221, 226) der Reihenschaltung zunächst so ausgelegt sind, dass ein Filterspeicher der Filtervorrichtung erhöht wird.

**Revendications**

1. Dispositif de filtre (200) pour filtrer un signal d'entrée (s(t)), comprenant :

   une pluralité de prises (210 à 216) ayant un coefficient de filtre respectif ($w_0$ à $w_6$) et une pluralité d'éléments à retard (221 à 226), dans lequel au moins deux éléments à retard (221 à 226) présentent des retards différents, caractérisé en qu'il comprend en outre
   un moyen d'ajustement configuré pour ajuster les retards des éléments à retard (221 à 226) du dispositif de filtre (200), dans lequel les éléments à retard (221 à 226) sont raccordés en série pour former un montage en série, ledit montage en série ayant un certain nombre d'éléments à retard centraux (222 à 225) disposés au centre du montage en série et un nombre respectif d'éléments à retard périphériques (221, 226) disposés sur des bords du montage en série, dans lequel le retard respectif des éléments à retard centraux (222 à 225) est plus faible que le retard respectif des éléments à retard périphériques (221, 226) et dans lequel l'élément à retard respectif (221 à 226) est disposé entre deux prises (210 à 216) ; et
   dans lequel le moyen d'ajustement est configuré pour prolonger les retards d'éléments à retard périphériques (221, 226) du montage en série d'abord de telle sorte qu'une mémoire de filtre du dispositif de filtre soit accrue.

2. Dispositif de filtre (200) selon la revendication 1,
   comprenant des moyens d'ajustement configurés pour ajuster le retard de l'élément à retard respectif (221 à 226) en fonction d'une position de l'élément à retard respectif (221 à 226) dans le dispositif de filtre (200).

3. Dispositif de filtre (200) selon l'une des revendications précédentes,
   dans lequel le retard respectif des éléments à retard centraux (222 à 225) est la moitié du retard respectif d'au moins l'un des éléments à retard périphériques (221, 226).

4. Dispositif de filtre (200) selon l'une des revendications précédentes,
   comprenant des moyens d'ajustement pour ajuster les retards des éléments à retard (221 à 226) du dispositif de filtre (200), dans lequel les moyens d'ajustement sont configurés pour ajuster le retard respectif de sorte qu'il soit un multiple d'un quotient entre une durée de symbole du signal d'entrée (s(t)) et un taux de suréchantillonnage utilisé pour échantillonner le signal d'entrée (s(t)).

5. Dispositif de filtre (200) selon l'une des revendications précédentes,
   dans lequel les éléments à retard (221 à 226) du dispositif de filtre (200) présentent au moins trois retards différents.

6. Dispositif de filtre (200) selon l'une des revendications précédentes,
   dans lequel le dispositif de filtre (200) est un filtre à réponse impulsionnelle finie (FIR).

7. Agencement de filtre comprenant :
   une pluralité de dispositifs de filtre (200) selon l'une des revendications précédentes configurés pour filtrer le signal d'entrée (s(t)).

8. Procédé pour fournir un dispositif de filtre (200) pour filtrer un signal d'entrée (s(t)), le procédé consistant :

   à fournir une pluralité de prises (210 à 216) ayant un coefficient de filtre respectif ($w_0$ à $w_6$) et
   à fournir une pluralité d'éléments à retard (221 à 226) disposés dans un montage en série, dans lequel au moins deux éléments à retard (221 à 226) présentent des retards différents, dans lequel un certain nombre d'éléments à retard centraux (222 à 225) est disposé au centre du montage en série et un nombre respectif d'éléments à retard périphériques (221, 226) est disposé sur des bords du montage en série, dans lequel le retard respectif des éléments à retard centraux (222 à 225) est plus faible que le retard respectif des éléments à retard périphériques (221, 226) ;
   le procédé étant caractérisé en qu'il fournit en outre un moyen d'ajustement configuré pour ajuster les retards des éléments à retard (221 à 226) du dispositif de filtre (200), dans lequel l'élément à retard respectif (221 à 226) est disposé entre deux prises (210 à 216), et
   dans lequel le moyen d'ajustement est configuré pour prolonger les retards d'éléments à retard périphériques (221, 226) du montage en série d'abord de telle sorte qu'une mémoire de filtre du dispositif de filtre soit accrue.

Fig. 1

Fig. 2

Fig. 3

Fig. 4

Fig. 5

Fig. 6

Fig. 7

**CD tolerance, DGD=72ps**

Fig. 8

Fig. 9

1001

1002

Fig. 10

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 5838740 A
- US 7120656 B
- US 3599108 A
- US 20090134938 A
- DE 102006053508
- EP 1557947 A1

### Non-patent literature cited in the description

- **T. DUTHEL et al.** Impairment tolerance of 111Gbit/s POLMUX-RZ-DQPSK using a reduced complexity coherent receiver with a T-spaced equalizer. *European Conference on Optical Communication,* 16 September 2007
- Background and preview'', Section 4: Linear Filter Structures. **SIMON HAYKIN.** Adaptive Filter Theory. Prentice Hall, 2002
- **NEVIO BENVENUTO ; GIOVANNI CHERUBINI.** Algorithms for Communications Systems and their Applications. Wiley, 2002